(19) Europäisches Patentamt
European Patent Office
Office européen des brevets

(11) Publication number: 0 318 840 A2

# (12) EUROPEAN PATENT APPLICATION

(21) Application number: 88119610.9

(51) Int. Cl.[4]: G03F 7/10

(22) Date of filing: 24.11.88

(30) Priority: 30.11.87 JP 303836/87

(43) Date of publication of application: 07.06.89 Bulletin 89/23

(84) Designated Contracting States: DE FR GB IT NL

(71) Applicant: National Starch and Chemical Corporation
Finderne Avenue P.O. Box 6500
Bridgewater, N.J. 08807 (New Jersey)(US)

(72) Inventor: Horikawa, Yukio
27-12, Shibagaki 1-chome
Matsubara-City Osaka(JP)
Inventor: Sayo, Koichi
2-17, Fukuzumidori 8-chome
Nada-ku Kobe-City(JP)
Inventor: Fujimoto, Masao
1-2, Minatojimanakamachi 3-chome
Chuo-ku Kobe-City(JP)

(74) Representative: Hagemann, Heinrich, Dr. Dipl.-Chem. et al
Patentanwälte HAGEMANN & KEHL
Ismaninger Strasse 108 Postfach 860329
D-8000 München 86(DE)

## (54) Method for forming image pattern of a film of a resin.

(57) A method for image pattern of a film of a resin on a substrate comprises the steps of applying on the substrate a solution of a polyisoimide resin comprising at least 80 mole % of a repetitive unit of an isoimide structure represented by the formula (I)

EP 0 318 840 A2

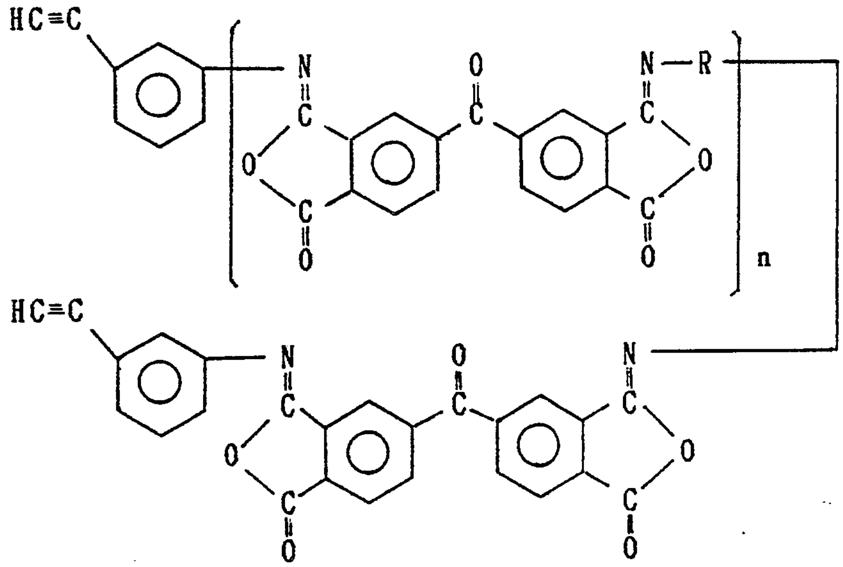

(I)

in which R represnts a divalent radical selected from the

group of 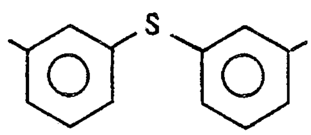 , 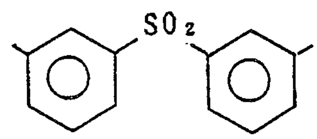 ,

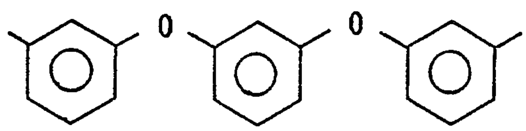 and 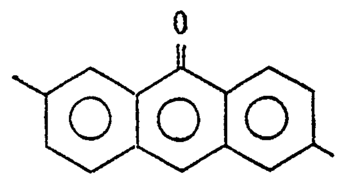

and n denotes an integer, and exposing the polyisoimide resin on the substrate to a light. In the method the solution of the polyisoimide resin with a sensitizer is preferably applied.

# METHOD FOR FORMING IMAGE PATTERN OF A FILM OF A RESIN

## BACKGROUND OF THE INVENTION

The present invention relates to a method for forming image pattern of a film of a resin on a substrate by utilizing a change of a solubility of a photosensitive resin due to a photochemical reaction.

On the growing demand for high density integration, miniaturization, light-weighing and high reliability for electronic devices and instruments, the so-called interlayer insulation of IC, LSI or so on, for which hitherto inorganic substances have been employed, has in recent years become realized by organic substances for the favorable features thereof. Heat-resistant substances, such as, polyimide resin etc., are employed as such organic substances. However, in case of using such substances, the patterning process involves a through hole step etc., which has been heretofore carried out by employing a photoresist layer placed on the film of, for example, polyimide.

This prior art patterning process employing the photoresist layer involves many process steps. In order to simplify this patterning process, there have been attempts to use photosensitized polyimide resin. Many of these attempts are based on the introduction of a photosensitive group into the molecule of a polyimide precursor, such as polyamic acid. However, the polyimide precursor having the photosensitive group have many disadvantages, for example, a few better solvents therefor and, in addition, the lower storage stability, that is, the polyimide precursor having the photosensitive group which is stored in solution is degraded, crosslinked or converted to imide in a quite short period and become unusable. Moreover, the use of the polyimide precursor involves a further process step of converting the precursor to the imide by a post-curing after the patterning process. During this post-curing, the photosensitive groups are decomposed and dissipated, so that decrease of the thickness of the film and occurrence of voids may not be avoided.

It has also been proposed to use a solvent-soluble polyimide resin into which photosensitive groups are introduced. However, the polyimide resins exhibite no sufficient solubility in solvents. Moreover, the photosensitive groups in these resins have also lower heat resistance as in the conventional resin. When post-curing is effected for improving the heat resistance, the photosensitive groups are decomposed and dissipated. Therefore, the use of the solvent-soluble polyimide resin has the same disadvantages as in the case of using the polyimide precursor mentioned above.

The inventors had been engaged in a sound study for solving the above difficulties and have reached to the completion of the present invention.

## SUMMARY OF THE INVENTION

An object of the invention is to provide a method for forming image pattern of a film of a resin on a substrate by employing a photosensitive resin which has high heat resistance and is superior in the solubility in solvents and in the storage stability without showing decrease of the thickness of the film and occurrence of voids upon the processing process.

The above object is attained by a method for forming image pattern of a film of a resin on a substrate comprising the steps of applying on the substrate a solution of a polyisoimide resin comprising at least 80 mole % of a repetitive unit of an isoimide structure represented by the formula (I)

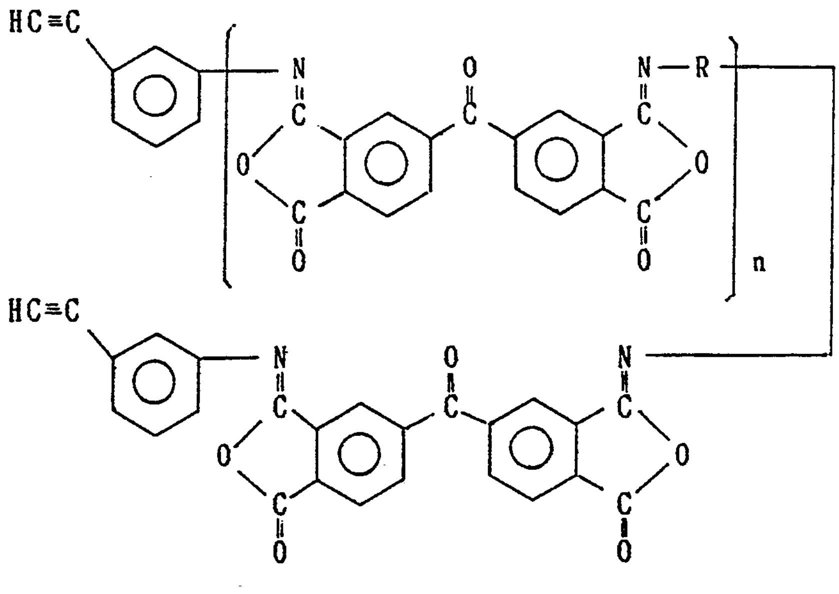

(I)

in which R represnts a divalent radical selected from the group of 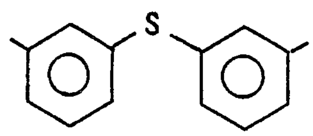 , 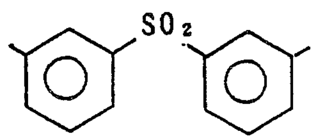 , 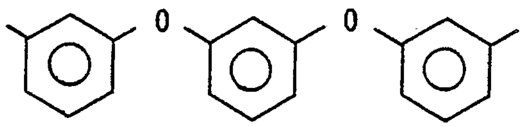 and 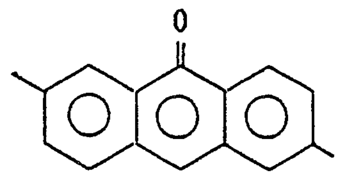

and n denotes an integer, and
exposing the polyisoimide resin on the substrate to a light.

In a preferred embodiment, the solution of the polyisoimide resin with a sensitizer is applied on the substrate.

This and other objects, advantages, and features will be fully understood from the following description.

## Detailed Description of the Preferred Embodiments

It is essential for the present invention to select a polyisoimide composition which will represent a large difference in the solubility between the polyisoimide itself and the reaction product produced by a photochemical reaction of the polyisoimide, that is, by exposing the polyisoimide to a light, and which provides a high heat resistance for the final polyimide product.

The polyisoimide resin represented by the above formula (I) according to the present invention can be produced by using a derivative of a tetracarboxylic acid or -anhydride and a diamine or diisocyanate as the starting substances.

For the divalent radical R in the general formula (I), those represented by the following formulae may be enumerated:

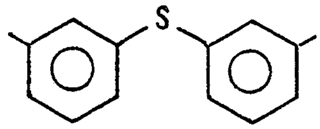
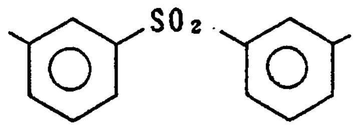

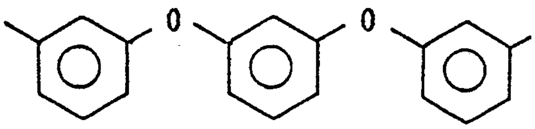
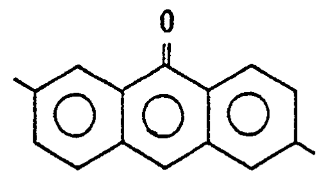

Among these, the radical 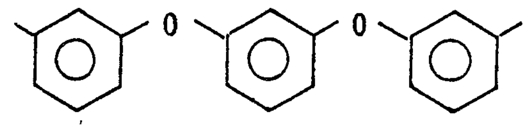 has shown to be most preferable.

For producing the above polyisoimide using the starting substances mentioned above, any suitable process among known processes may be selected. One concrete example of such process comprises the steps of reacting a tetracarboxylic acid dianhydride with a diamine and a 3-aminophenyl-acetylene (abbreviated hereinafter as APA) in a solvent, such as, N,N-dimethylacetamide, N-methyl-2-pyrrolidone or the like, condensing the so obtained polyamic acid with dehydration under the use of a condensing agent (dehydrating agent), such as, trifluoroacetic acid anhydride, dicyclohexyl carbodiimide or the like, and converting the condensation product to the isoimide.

The thus obtained polyisoimide is then, after purification thereof, dissolved in an adequate solvent, such as, dioxane, N,N-dimethylacetamide, N-methyl-2-pyrrolidone, diglyme, dimethyl sulfoxide or so on. The resulting solution is poured on a substrate, such as silicon wafer, and is spread over it to form a film. The thickness of the film may be adjusted within the range from 1 to 100 µm in accordance with each specific purpose by selecting adequately the concentration of the polyisoimide solution and the applying conditions of a spinner, etc. After evaporating off the solvent to dry the film it is exposed to a light from a suitable light source, such as, a mercury-vapor lamp or so on, through a photomask. For the light to use to expose the film, an ultraviolet ray of 300 nm - 400 nm maybe employed preferably, which may be obtained by a high pressure or low pressure mercury-vapor lamp.

It is also possible to add to the polyisoimide a sensitizer such as acenaphthene etc.

The exposure duration may be chosen adequately in accordance with the strength of the light source, the thickness of the film of the polyimide precursor, and if necessary, the kind and the concentration of the sensitizer, and so on, while usually it is in the range from 10 sec. to 30 minutes. If an effective sensitizer is added to the solution, the exposure duration can be shortened. Particularly, 5-nitroacenaphthene and 2-chloro-4-nitoroaniline is effective. The amount to be added of a sensitizer is preferably 0.1 to 10 % by weight, relative to the weight of the resin. It is not suitable to add above 10 % of the sensitizer, because volantile substances on curing will increase. The reason that addition of the sensitizer is effective is not clear, but it will be supposed that the photosensitivity of the resin of this invention is due to the change of the solubility of the resin in the solvent by the photo-isomerization, though the photoreaction of a conventional photosensitive resin is based on bindings of vinyl groups, so that the sensitizer is more preferable than an initiator of photopolymerization which emits radicals.

The isoimide of the polyimide precursor is converted into imide etc. by the photochemical reaction, whereby the solubility of the resin in the solvent will considerably decrease. Therefor, the image pattern of the film of the resin can appear by using a solvent (a developing solution) which can dissolve off only the non-expozed portion of the film. The developing solvent can be selected from the solvents in which oligomer based on isoimide can be dissolved and isomerized oligomer based on imide can not be dissolved, dependent on the thickness of the film, the molecular weight of the oligomer and the developing duration. The concrete developing solvents may contain diglyme, dioxane, tetrahydrofuran, N,N-dimethylacetamide, N-methyl-2-pyrrolidone, dimethyl sulfoxide and so on, solely or in mixture with other solvent having lower solubility, such as, toluene, xylene, ethyl alcohol, isopropyl alcohol or so on.

There are many method of developing the exposed photosensitive resin, such as by immersed into the

developing solvent for a certain time. It is advantageous in this invention to immerse the exposed resin into the developing solvent and then treat the resin by an ultrasonic wave in order to promote the elution of the unexposed part of the resin. The higher the degree of polymerization of the polyimide precursor, the lower the rate of the elution, and the thicker the thickness of the film, the longer the eluting duration. The decrease of the eluting rate can be attained by using a mixture of a solvent having higher solubility with a solvent having lower solubility. In practice, the ratio of the soluble solvent to the insoluble solvent is dependent on the degree of polymerization of the oligomer and the thickness of the film on curing, and can be adequately selected from the above view points. In the concrete, in case of lower degree of polymerization of the oligomer, the ratio of the soluble solvent to the insoluble solvent may be increased because of higher rate of elution. In case of higher degree of polymerization of the oligomer, the ratio is decreased and the duration of developing by the ultrasonic wave is increased.

It is also advantageous to rinse the exposed resin with isopropyl alcohol etc. after the developing.

The so developed remaining portions of the film after the exposure and development explained above can be then subjected to a heat treatment to convert the remaining isoimide into imide and to cause the terminal acetylene groups to combine together to form a polyimide film in the configuration corresponding to the exposed image. The condition of the heat treatment may be different in accordance with the requisite Tg (glass transition temperature) of the polyimide film forming image pattern. In general, with the increase in the temperature and the treatment duration, Tg of the resin will be increased, while usually it is enough to perform the heat treatment at a temperature of 200 - 450 °C for about 1 - 24 hours. It is of course possible to employ a stepwise heat treatment by, for example, heating at 250 °C for 30 minutes, at 300 °C for 30 minutes and at 400 °C for 1 hour, while the velocity of increasing or decreasing the temperatuer is not critical.

By method for forming image pattern of the film of the photosensitive polymer according to the present invention, image patterns in a high reliability can be obtained very easily, since it causes lower decomposition and dissipation of the photosensitive components and offers little decrease of the thickness of the fim together with scarce formation of voids during the heat treatment. The cured polyimide resin according to the invention has partly three-dimensionally cross-linked structure and, due to its wholly aromatic nature, exhibits a superior heat resistance and has excellent adhesion on various surfaces of, such as, silicon, alumina and various other substances including nitrogen, silicon and so on. The resulting polyimide according to the present invention has also far superior water-resistance as compared with various linear polyimides. Thus, the moisture content of the polyimide after 1,000 hours at 50 °C under a relative humidity of 90 % is found to be below only 1 %. It also exhibits quite better electrical properties.

In the following, the present invention will be further described by examples.

## EXAMPLE 1

As the polyimide precursor of isoimide type, three commercial products. Thermid IP-600, IP-615 and IP-630 of the National Starch and Chemical Corp. were employed to which 5-nitroacenaphtene is added as a sensitizer in an amount of 5 % by weight, relative to the weight of the polyimide precursor. The above products correspond to the compounds of the formula (I) in which n equals in the average to 1, 15 and 30 respectively.

Each of these Thermids was dissolved in a solvent as given in Table 1 and a glass disk having a radius of 4 inches was coated with each of the resulting solutions using a spinner under a coating condition of 3,000 - 5,000 r.p.m. over a period of 60 sec., whereupon the coated layer was dried at 80 °C for 1 hour.

A test pattern (Hoya Test Pattern No. 3-K-1) was placed on each of the glass disk coated with the Thermid and the glass disc was exposed to an ultraviolet ray from a 500 W high pressure mercury-vapor lamp at a distance between the disk and the lamp of 20 cm for 3 minutes.

The so exposed glass disc was immersed in each of the developing solvent listed up in Table 1 and was subjected to an ultrasonic wave treatment for 30 seconds, in order to dissolve off the unexposed portions of the coating layer.

This developed glass disk was then subjected to a heat treatment under nitrogen stream in a drying apparatus, that is, heated from an ordinary temperature to 250 °C and kept at this temperature for 30 minutes, and 300 °C for 30 minutes and finally at 400 °C for 3 hours, whereby a hardened polyimide having partially three-dimensionally cross-linked structure was obtained.

The results shows as follows:

TABLE 1

| Experiment No. | Polyimide Precursor | | Solvent of the Precurs. | Spinner Velocity (r.p.m.) | Developing Solvent | Layer Thickness (μm) | Width of Line * (μm) |
|---|---|---|---|---|---|---|---|
| | Product | (Conc.) | | | | | |
| 1 | Thermid IP-600 | 30 (wt.%) | Diglyme | 3,000 | Dioxane/Toluene (0.5/0.5) | 1.0 | 2 |
| 2 | Thermid IP-600 | 30 (wt.%) | Diglyme | 3,000 | Dioxane/i-propanol (0.6/0.4) | 1.0 | 2 |
| 3 | Thermid IP-615 | 30 (wt.%) | Dioxane | 5,000 | Dioxane | 2.9 | 3 |
| 4 | Thermid IP-615 | 30 (wt.%) | Dioxane | 5,000 | Dioxane/Toluene (0.7/0.3) | 2.9 | 3 |
| 5 | Thermid IP-615 | 30 (wt.%) | N,N-dimethylacetamide | 5,000 | Tetrahydrofuran/Toluene (0.7/0.3) | 2.9 | 3 |
| 6 | Thermid IP-630 | 20 (wt.%) | N-methylpyrrolidone | 5,000 | Tetrahydrofuran | 2.0 | 3 |
| 7 | Thermid IP-630 | 20 (wt.%) | N-methylpyrrolidone | 5,000 | N-methylpyrrolid./i-Propanol (0.6/0.4) | 2.0 | 2 |

Note: *: Width of the finest line developed in the pattern.

As shown in Table 1, a pattern having a line width 2 -3 µm could be obtained in a sharp reproduction. A separately heat-cured Thermids IP-600, IP-615 and IP-630 had shown all excellent heat resistances each with a burning weight loss temperature of at least 500 °C. The electrical properties thereof were also sufficient for employing for insulation materials.

## EXAMPLE 2

This example shows the effect of addition of a sensitizer.

A quarts glass was coated with the solution of Thermid 600, if necesarry, to which a sensitizer as given in Table 2 was added 10 % by weight, by using a spinner under a coating condition of 5,000 r.p.m. over a period of 30 sec, whereby the thickness of the coated layer was about 1 micron.

The glass coated with the Thermid was exposed to a UV light for 10 min. and developed with dioxane for 2 min.

The results are as follows:

Table 2

| Kind of Sensitizer | Absorbance (290nm) | | | Remaining Ratio |
|---|---|---|---|---|
| | Exposing | | Developing | |
| | Before | After | After | |
| 5-Nitoroacenaphthene | 0.96 | 0.90 | 0.78 | 80.6 |
| 2-Chloro-4-nitroaniline | 0.94 | 0.92 | 0.74 | 78.0 |
| IP-600 only | 0.90 | 0.82 | 0.22 | 24.1 |
| Remaining ratio = (absorbance (after developing)-0.03)/(absorbance (before exposing)-0.03) x 100 | | | | |

wherein the number 0.03 is the value of the blank, that is, the absorbance of the quarts glass.

## Claims

1. A method for forming image pattern of a film of a resin on a substrate comprising the steps of applying on the substrate a solution of a polyisoimide resin comprising at least 80 mole % of a repetitive unit of an isoimide structure represented by the formula (I)

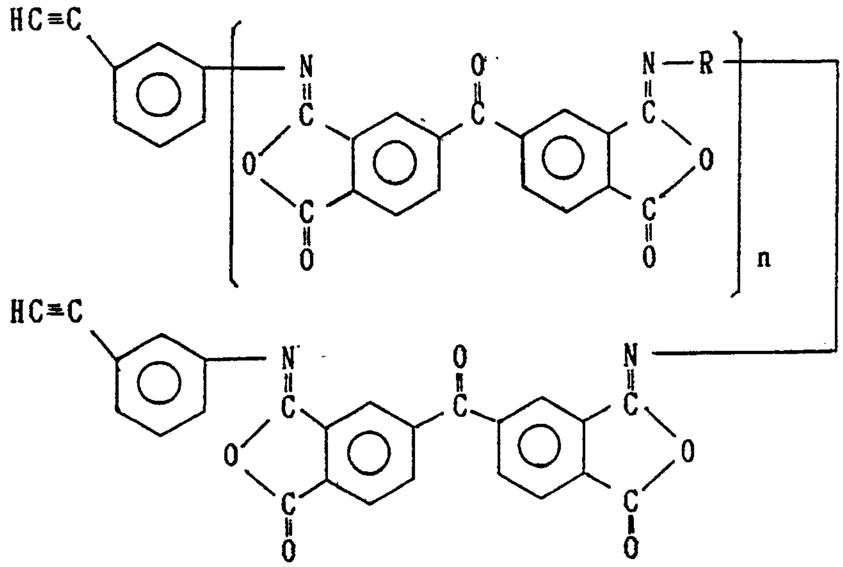

(I)

in which R represnts a divalent radical selected from the group of 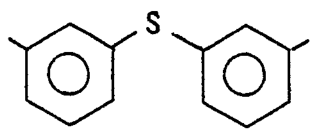 , 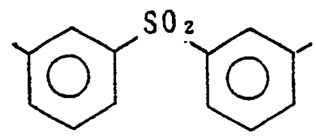 , 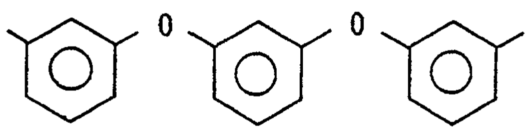 and 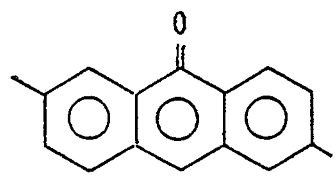

and n denotes an integer, and exposing the polyisoimide resin on the substrate to a light.

2. The method according to Claim 1, wherein the solution of the polyisoimide resin with a sensitizer is applied.

3. The method according to Claim 2, wherein the sensitizer is selected from the group consisting of 5-nitroacenaphthene and 2-chloro-4-nitroaniline.